(19) Europäisches Patentamt / European Patent Office / Office européen des brevets

(11) **EP 2 549 654 A1**

(12) **DEMANDE DE BREVET EUROPEEN**

(43) Date de publication:
**23.01.2013 Bulletin 2013/04**

(51) Int Cl.:
*H03K 19/00* ^(2006.01)      *H03K 19/02* ^(2006.01)

(21) Numéro de dépôt: **12177104.2**

(22) Date de dépôt: **19.07.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **22.07.2011  FR 1156670**

(71) Demandeur: **Commissariat à l'Énergie Atomique et aux Énergies Alternatives**
**75015 Paris (FR)**

(72) Inventeur: **Fanet, Hervé**
**38420 Revel (FR)**

(74) Mandataire: **Ilgart, Jean-Christophe**
**BREVALEX**
**95 rue d'Amsterdam**
**75378 Paris Cedex 8 (FR)**

(54) **Circuit logique à faible consommation et circuit intégré comportant au moins un tel circuit logique**

(57)    Circuit logique pour circuit intégré comportant une source de tension d'alimentation ($V_{alim}$) variable dont la variation comporte au moins trois phases successives, une première phase d'augmentation de la tension d'une valeur nulle à une tension nominale ($V_{DD}$), une deuxième phase de maintien de la tension d'alimentation à la tension nominale ($V_{DD}$) et une troisième phase de diminution de la tension d'alimentation de la tension nominale ($V_{DD}$) à une valeur nulle, et au moins deux interrupteurs mécaniques (2, 4), lesdits interrupteurs (2, 4) étant des interrupteurs microélectromécaniques ou des interrupteurs nanoélectromécaniques, et des moyens de commutation desdits interrupteurs.

FIG.2

**Description**

**DOMAINE TECHNIQUE ET ART ANTÉRIEUR**

La présente invention se rapporte à un circuit logique à faible consommation et à des circuits intégrés comportant au moins un tel circuit logique.

Les circuits logiques de l'état de la technique sont réalisés en technologie CMOS ("Complementary Metal-Oxide Semiconductor" en terminologie anglo-saxonne) qui associe une paire de transistors complémentaires, l'un de type N, l'autre de type P, sur un même support.

En particulier à cause du développement des systèmes électroniques autonomes, on cherche à contrôler la consommation des circuits intégrés afin de la réduire. Plusieurs solutions peuvent être mises en oeuvre, l'une consiste à réduire la tension d'alimentation des circuits, en effet la consommation dite dynamique est proportionnelle au carré de cette tension, l'autre solution consiste à favoriser la mise en oeuvre de plusieurs circuits fonctionnant à des fréquences relativement lentes par rapport à un système fonctionnant à fréquence élevée. Cependant ces solutions présentent des limites liées à la réduction de taille de transistors.

Il existe une autre solution appelée logique adiabatique qui consiste à contrôler de manière optimale les charges et décharges des capacités d'un circuit intégré, ces capacités étant principalement celles des lignes d'interconnexion qui sont nettement supérieures à celles des transistors. La logique adiabatique est décrite dans le document W C Athas, "Low power Digital systems based on adiabatic switching principles", IEEE transactions on VLSI systems VOL 2, N04 December 1994.

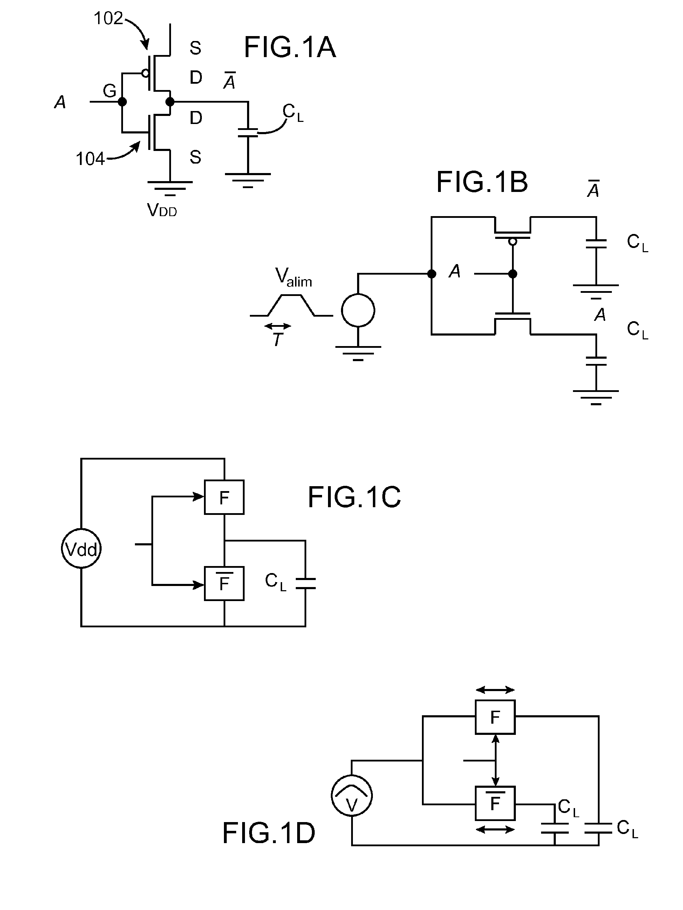

Sur la figure 1A, on peut voir un inverseur logique en technologie CMOS classique. L'inverseur logique comporte un transistor p et un transistor n 102, 104. G, S et D désigne respectivement la grille, la source et le drain des transistors. A et son complément désignent les signaux de commande. De manière plus générale la figure 1C montre comment réaliser une fonction logique quelconque en fonction des entrées, le circuit associé étant une combinaison de transistors en série ou en parallèle. La fonction inverseur est simplement réalisée par un transistor, un PMOS pour F et un NMOS pour la fonction complémentaire.

Dans la logique classique, à chaque changement d'état, la capacité $C_L$ des lignes d'interconnexion est chargée à la tension d'alimentation $V_{DD}$ puis déchargée à la masse. Une énergie est donc dissipée thermiquement qui peut s'écrire pour un cycle :

$$E = 2.\frac{1}{2} \cdot C_L \cdot V_{DD}{}^2$$

On peut montrer de manière théorique que pour minimiser l'énergie dissipée par effet Joule dans la résistance en série avec une capacité, il faut garantir que les opérations de charge et de décharge s'effectuent à courant constant. Dans ce cas il est facile de montrer que l'énergie dissipée pendant le temps T pendant lequel on charge ou on décharge la capacité s'écrit :

$$E = \frac{RC_L}{T} \cdot C_L \cdot V_{DD}{}^2$$

La résistance R est la somme des résistances entre l'alimentation et l'entrée de la ligne d'interconnexion (résistance de l'interrupteur utilisé + résistances des lignes de connexion). Pour établir ce résultat, Il suffit de résoudre le système d'équations :

$$Q = iT$$

$$Q = C_L V_{DD}$$

$$E = Ri^2 T$$

Q est la charge stockée dans la capacité de la ligne d'interconnexion (en fait cette capacité plus la capacité d'entrée de l'étage suivant mais en général beaucoup plus faible).

Le courant constant de charge et de décharge est i.

La tension à établir sur la ligne d'interconnexion est la tension d'alimentation (la charge étant supposée quasi-totale).

T est le temps pendant lequel on charge ou on décharge la ligne d'interconnexion.

En pratique, pour se rapprocher de cette condition idéale, les circuits proposés à ce jour sont basés sur une variation linéaire de la tension d'alimentation pendant les opérations de charge et de décharge des capacités ce qui revient au premier ordre à travailler à courant constant. Le cas de l'inverseur permet de préciser ce mode de fonctionnement.

En logique adiabatique, dans le cas de l'inverseur représenté sur la figure 1B, la tension d'alimentation n'est plus constante comme dans la logique classique, mais est établie relativement lentement à chaque changement d'état. Les entrées (input) sont positionnées puis la tension d'alimentation $V_{alim}$ est progressivement amenée à la tension nominale $V_{DD}$ pendant un temps T, ce qui permet d'établir le niveau de sortie puis de transmettre ce niveau aux portes suivantes. L'opération contraire est ensuite effectuée pour remettre le système à zéro et traiter un autre événement logique. De la même manière, la tension d'alimentation $V_{alim}$ est alors relativement lentement baissée de $V_{DD}$ à zéro. Les entrées sont ensuite également portées au potentiel zéro en attente d'un nouveau changement d'état.

La figure 1D représente une fonction logique équivalente à celle de la figure 1C réalisée en logique adiabatique.

Le plus souvent les portes adiabatiques réalisent aussi la fonction complémentaire comme il est indiqué sur les figures 1A à 1D et de ce fait utilisent aussi en entrée non seulement les grandeurs logiques mais aussi leurs compléments. Cette logique adiabatique particulière est appelée « dual rail ».

Dans la mesure où la capacité $C_L$ est chargée et déchargée lentement par rapport à la constante de temps typique du circuit $RC_L$, R étant la résistance globale associée au processus de charge et de décharge, qui inclut la résistance de sortie du ou des transistors réalisant les fonctions F ainsi que la résistance des connexions, la tension aux bornes de la capacité $C_L$ peut suivre la tension appliquée en entrée. La tension aux bornes de la résistance est donc quasi nulle et la consommation thermique peut donc être réduite de manière importante par rapport à la logique classique.

L'énergie dissipée lors de la charge peut alors s'écrire comme dans le cas idéal de la charge à courant constant :

$$E = \frac{RC_L}{T} \cdot C_L \cdot V_{DD}^{\,2}$$

Lors de la décharge une énergie équivalente est dissipée.

Par conséquent l'énergie dissipée en logique adiabatique peut être réduite de manière importante à condition que la période T soit très supérieure aux constantes de temps $RC_L$.

En pratique, la forme en trapèze du signal d'alimentation est souvent remplacée par un signal sinusoïdal ou en partie sinusoïdal plus facile à générer et constituant une approximation convenable.

Cette logique n'a cependant donné lieu à aucune réalisation industrielle. En effet, le calcul exposé ci-dessus ignore une caractéristique des transistors réalisés dans une technologie à base de semi-conducteurs à savoir l'effet de seuil. Pour rendre le transistor (ou les transistors) conducteurs dans la phase de charge ou de décharge des capacités, il faut que la tension de commande appliquée à la grille dépasse une valeur appelée tension de seuil et notée $V_T$ dans la technologie CMOS. En général la tension de commande et la tension d'alimentation sont de même valeur pour simplifier l'architecture. Dans le cas de l'inverseur de la figure 1B, lorsque l'entrée est à l'état «0», le transistor PMOS devient conducteur quand la tension d'alimentation est supérieure à la tension de seuil du transistor. Dans ce cas, une différence de tension va apparaître aux bornes de la résistance R dans le processus de charge (ou de décharge) tant que le transistor n'est pas conducteur. Cette valeur varie de 0 à $V_T$ pendant le cycle. Un courant non négligeable apparaît alors aux bornes de la résistance et génère une dissipation thermique.

L'énergie dissipée dans le processus de charge peut s'écrire en première approximation :

$$E = \frac{RC_L}{T} \cdot C_L \cdot V_{DD}{}^2 + \frac{1}{2}C_L \cdot V_T{}^2$$

Pour réduire cet effet négatif il faudrait réduire la tension de seuil $V_T$ à une valeur proche de 0, mais dans la technologie CMOS cette solution est inapplicable car elle conduirait à une consommation statique non tolérable due au courant sous le seuil. La consommation statique est liée au courant de fuite des transistors (conduction résiduelle en dessous du seuil), elle varie exponentiellement avec la diminution de la tension de seuil et des rapports $V_T/V_{DD}$ supérieurs à 0,2 voire 0,3 dans des technologies basse consommation sont nécessaires.

Par conséquent, la logique adiabatique théoriquement d'un grand intérêt est incapable de réduire largement la consommation des circuits réalisés dans une technologie d'interrupteurs à base de semi-conducteurs, présentant des effets de seuil.

## EXPOSÉ DE L'INVENTION

C'est par conséquent le but de la présente invention d'offrir un circuit logique à consommation d'énergie très faible.

Le but précédemment énoncé est atteint par un circuit logique en logique adiabatique ; i.e. alimenté par une source de tension d'alimentation apte à charger et de décharger à courant quasi constant une ligne d'interconnexion à travers des interrupteurs mécaniques, et mettant en oeuvre des interrupteurs microélectromécaniques ou MEMS ou nanoélectromécaniques ou NEMS à la place des transistors N et P.

D'une part de tels interrupteurs mécaniques ne présentent pas de tension de seuil au sens des semi-conducteurs. Quand le contact est établi, une valeur très petite de la tension appliquée suffit à faire passer un courant sans avoir à franchir une tension de seuil. En outre, ils présentent une dissipation statique négligeable à l'inverse des transistors. Par conséquent l'énergie dissipée est réduite par rapport à celle dissipée par les CMOS.

D'autre part, de manière particulièrement intéressante, la combinaison d'interrupteurs mécaniques avec une actuation électrostatique et de la logique adiabatique permet d'obtenir un circuit intégré dont l'énergie dissipée est au premier ordre indépendante de la tension d'alimentation, ce qui permet de réaliser des circuits basse consommation sans nécessité de mettre en oeuvre des tensions d'alimentation très faibles. La tension de fonctionnement peut être choisie librement ce qui évite de devoir travailler à des tensions très faibles comme en CMOS.

Cet effet est complètement inattendu pour l'homme du métier qui associe généralement faible consommation et faible tension d'alimentation.

Grâce à l'invention, dans le cas de dispositifs ultra basse consommation, il n'est plus nécessaire de réduire la tension d'alimentation, une telle réduction ayant des effets négatifs sur la fiabilité.

Dans le cas d'un circuit intégré qui mettrait en oeuvre un ou plusieurs interrupteurs mécaniques en logique classique, les tensions d'alimentation devraient être abaissées en dessous de 200 mV pour pouvoir présenter un avantage important par rapport aux circuits intégrés CMOS. Cependant de telles tensions d'alimentation imposeraient des jeux entre la structure mobile et la base de l'interrupteur de l'ordre de quelques nanomètres, ce qui impliquerait de difficultés technologiques de réalisation très considérables.

Grâce à l'invention, de telles contraintes technologiques sont supprimées. Un jeu compris entre 5 nm et 100 nm entre la structure mobile et le base dans les interrupteurs peut être mis en oeuvre.

Alors que les interrupteurs mécaniques sont considérés par l'homme du métier du domaine des circuits intégrés comme lents, présentant une résistance de contact élevée dans le cas des interrupteurs de petites dimensions et pouvant en outre être sujet à des problèmes de collage, l'inventeur de la présente invention est aller à l'encontre des préjugés sur les interrupteurs mécaniques en les utilisant pour réaliser les portes logiques en logique adiabatique et a obtenu des résultats inattendus de cette combinaison. En particulier, l'indépendance au premier ordre de l'énergie dissipée par rapport à la tension d'alimentation.il en résulte que la tension d'alimentation peut être relativement élevée ce qui procure l'avantage inattendu de résoudre les problèmes de collage, puisque ceux-ci sont notablement réduits lorsque la tension appliquée est faible.

La présente invention présente l'avantage de ne pas être le siège de courant de fuite. En logique adiabatique, il est alors possible de choisir arbitrairement la fréquence de fonctionnement ce qui est impossible avec des MOS, puisqu'il faut atteindre un compromis énergie statique-énergie dynamique ce qui conduit à une fréquence optimale de fonctionnement.

En outre, les interrupteurs mécaniques ne présentent pas de tension de seuil ce qui conduit à éliminer les résidus non adiabatiques dans la dissipation, contrairement aux interrupteurs MOS qui conduisent à des termes dépendant du carré de la tension de seuil.

La présente invention a alors pour objet un circuit logique pour circuit intégré comportant :

- une source de tension d'alimentation apte à charger et de décharger à courant quasi constant une ligne d'interconnexion à travers des interrupteurs mécaniques :
- une ligne d'interconnexion,
- des interrupteurs mécaniques, lesdits interrupteurs étant des interrupteurs microélectromécaniques ou des interrupteurs nanoélectromécaniquees,
- des moyens de commutation desdits interrupteurs.

Dans un mode avantageux, la source de tension d'alimentation est variable selon au moins trois phases successives, une première phase d'augmentation de la tension d'une valeur nulle à une tension nominale, une deuxième phase de maintien de la tension d'alimentation à la tension nominale et une troisième phase de diminution de la tension d'alimentation de la tension nominale à une valeur nulle, et au moins deux interrupteurs mécaniques lesdits interrupteurs étant des interrupteurs microélectromécaniques ou des interrupteurs nanoélectromécaniquees, et des moyens de commutation desdits interrupteurs.

Par exemple, chaque interrupteur comporte deux pistes conductrices électriques, dont l'une est connectée à la source de tension d'alimentation et une partie mobile destinée à venir en contact avec les deux pistes dans un état de fermeture de l'interrupteur, et les moyens de commutation mettant en oeuvre une tension de commande pour déplacer la partie mobile.

De manière préférée, les moyens de commutation sont de type électrostatique et comportent une électrode fixe en regard d'une partie au moins de la partie mobile et des moyens d'application de la tension de commande positive pour attirer la partie mobile vers l'électrode fixe et mettre en contact la partie mobile avec les pistes conductrices.

Avantageusement la tension d'alimentation est égale à la tension de commande.

Par exemple, la durée de la première phase est comprise entre 1 et 100 ns, et la tension d'alimentation nominale peut être comprise entre 100 mV et 10 V.

En variante, les moyens de commutation sont de type magnétique ou piézoélectrique.

Le circuit logique selon l'invention peut être un inverseur logique ou un circuit NON OU ou NON ET ou ET ou OU ou une porte de Toffoli ou une porte de Fredkin ou une porte de Feynman.

La présente invention a également pour objet un circuit intégré comportant au moins un premier et un deuxième circuit logique selon la présente invention.

Dans un mode de réalisation, la tension de sortie de la première porte commandant la deuxième porte.

## BRÈVE DESCRIPTION DES DESSINS

La présente invention sera mieux comprise à l'aide de la description qui va suivre et des dessins joints en annexe sur lesquels :

- les figures 1A à 1D sont des portes logiques de l'état de la technique,
- la figure 2 est un exemple d'inverseur logique selon la présente invention,
- les figures 3A, 3B et 3C sont des exemples de portes NON OU (ou NOR en terminologie anglo-saxonne) et NON ET (NAND) logiques selon la présente invention,
- la figure 4 est une vue complète d'une représentation schématique d'un interrupteur mécanique pouvant être mis en oeuvre dans la présente invention,
- les figures 5A et 5B sont des vues de côté de l'interrupteur de la figure 4 dans un état fermé et dans un état ouvert respectivement,
- les figures 6A et 6B sont des vues de dessus et en coupe d'un exemple de réalisation d'un interrupteur mécanique à commande magnétique utilisable dans la présente invention,
- les figures 7A et 7B sont des vues en coupe longitudinale d'un exemple de réalisation d'un interrupteur mécanique à commande piézoélectrique utilisable dans la présente invention, dans un état en cours de fermeture et dans un état ouvert respectivement.

## EXPOSÉ DÉTAILLÉ DE MODES DE RÉALISATION PARTICULIERS

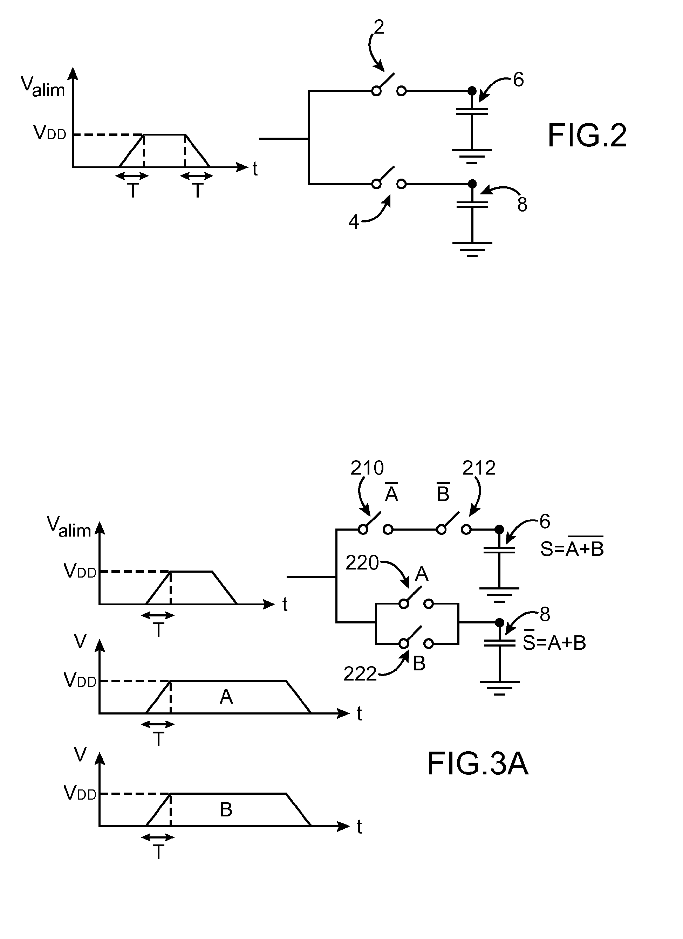

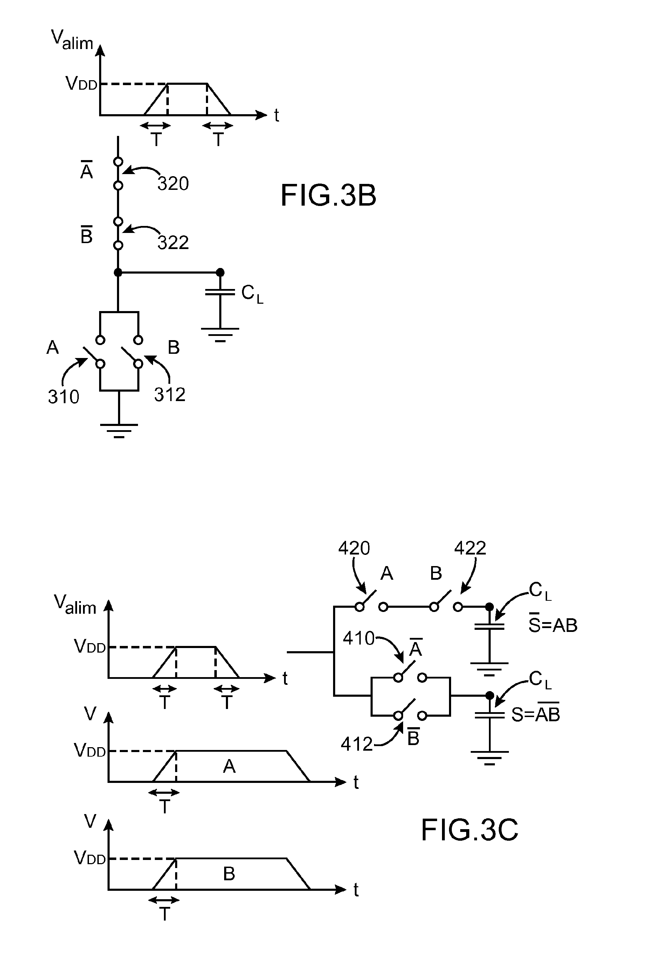

Sur les figures 2 et 3, nous pouvons voir deux exemples de portes logiques selon la présente invention. Sur la figure 2, il s'agit d'un inverseur logique et sur la figure 3A, il s'agit d'un exemple de porte NON-OU ou (NOR en terminologie anglo-saxonne). Sur la figure 3B, on peut voir un autre exemple de porte NOR et sur la figure 3C, on peut voir un exemple de réalisation d'une porte NON-ET (NAND en terminologie anglo-saxonne).

Ces portes logiques comportent, en lieu et places des transistors des interrupteurs mécaniques, plus particulièrement des nanointerrupteurs ou microinterrupteurs réalisés par technologie NEMS (Nanoelectromechanical Systems) ou MEMS (Microelectromechanical Systems). La fermeture et parfois l'ouverture de ces interrupteurs peuvent être commandées par des moyens électrostatiques, par application d'un champ magnétique, par effet piézoélectrique, par effet thermique...

A des fins de simplicité, les " nano et microinterrupteurs " seront désignés uniquement par " interrupteurs mécaniques ".

Sur le circuit de la figure 2 sont schématisés les deux interrupteurs mécaniques 2, 4, l'un 2 réalisant la fonction F et l'autre 4 réalisant la fonction complémentaire $\overline{F}$.

Les condensateurs 6, 8 de capacité $C_L$ symbolisent les capacités des lignes d'interconnexion.

La tension d'alimentation désignée $V_{alim}$ est appliquée en entrée des deux interrupteurs mécaniques 2, 4.

Dans le cas d'interrupteurs à commande électrostatique, une tension de commande V assure la fermeture des interrupteurs 2, 4.

Selon l'invention, la porte de la figure 2 fonctionne en logique adiabatique, i.e. la source de tension d'alimentation est telle qu'elle permet de charger et de décharger à courant quasi constant une ligne d'interconnexion à travers les interrupteurs mécaniques.

Par exemple, la source d'alimentation en tension est telle que la tension d''alimentation $V_{alim}$ n'est pas constante et varie selon un profil trapézoïdal. La variation de la tension $V_{alim}$ est représentée schématiquement sur les figures 2 et 3. Dans une première phase I, la tension d'alimentation croît progressivement de 0 jusqu'à atteindre la tension nominale $V_{DD}$, pendant un temps T, ce qui permet d'établir le niveau de sortie puis de transmettre ce niveau aux portes suivantes. Dans une deuxième phase II, la tension d'alimentation $V_{alim}$ est maintenue pendant un certain temps à la tension nominale $V_{DD}$ et ensuite, lors d'une troisième phase III, la tension d'alimentation $V_{alim}$ décroît pendant le temps T pour remettre le système à zéro et traiter un autre événement logique. Les entrées sont ensuite également portées au potentiel zéro en attente d'un nouveau changement d'état.

Le temps d'augmentation de la tension et le temps de diminution de la tension sont de préférence sensiblement égaux. En outre, le temps pendant lequel la tension est constante est sensiblement constant. En pratique, le profil trapézoïdal est approximé par une demi-sinusoïde.

Dans la logique adiabatique appelée également " logique à récupération d'énergie " (energy recovery logic en anglais), l'énergie stockée dans la capacité de l'interconnexion n'est pas déchargée à la masse comme dans la logique CMOS ce qui introduit nécessairement une dissipation, mais vers l'alimentation qui a servi à la charger. Une grande partie de l'énergie est donc récupérée par l'alimentation. La logique adiabatique est également appelée logique à récupération d'énergie (energy recovery logic en anglais).

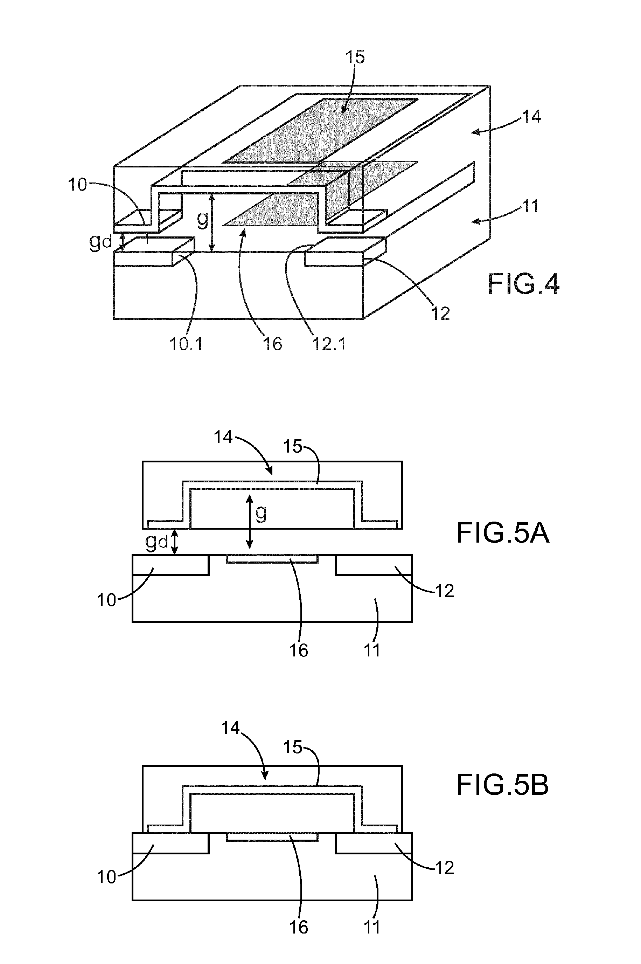

Sur la figure 4, on peut voir, en vue de dessus, un exemple de réalisation d'un interrupteur mécanique 2 adapté à la présente invention.

L'interrupteur est destiné à connecter électriquement deux pistes 10, 12 réalisées sur la surface du circuit intégré, l'interrupteur comporte un moyen de connexion formé par une partie mobile 14 munie d'une électrode de commande 15 disposée au-dessus des deux pistes 10, 12 et une électrode fixe 16 sur la partie fixe 11 du circuit intégré et dont une partie au moins est en regard de la partie mobile 14. Dans l'exemple représenté, la partie mobile 14 est de type cantilever. Elle pourrait être formée par une membrane.

Dans l'exemple représenté, les deux pistes 10, 12 sont alignées et comportent deux extrémités libres 10.1, 12.1 respectivement en regard, l'électrode fixe 16 est située entre les extrémités libres 10.1, 12.1 des deux pistes 10, 12, et la partie mobile 14 chevauche les deux extrémités 10.1, 12.1 des pistes 10, 12 et est perpendiculaire à l'électrode fixe.

La partie mobile 14 est, en l'absence de tension positive appliquée, entre la partie mobile 14 et l'électrode fixe 16 maintenue suspendue au-dessus des pistes par des éléments élastiques type poutres. Lorsqu'une tension de commande suffisante est appliquée, la partie mobile se rapproche des pistes sous l'effet de la force électrique et entre en contact avec celles-ci de sorte à assurer la connexion électrique avec celle-ci. Par exemple la partie mobile est du type levier (ou "cantilever" en terminologie anglo-saxonne").

Sur la figure 5A, on peut voir de côté l'interrupteur de la figure 4, dans un état ouvert (état logique 2), en l'absence d'une tension de commande positive appliquée entre l'électrode fixe et la partie mobile et sur la figure 5B, l'interrupteur est dans un état fermé (état logique 1) par application d'une tension de commande positive entre l'électrode fixe 16 et la partie mobile 14, les deux pistes 10, 11 sont connectées et le courant peut circuler entre les deux pistes 10, 12.

La structure d'interrupteur représentée sur la figures 4, 5A et 5B n'est qu'un exemple de réalisation et n'est en aucun cas limitative.

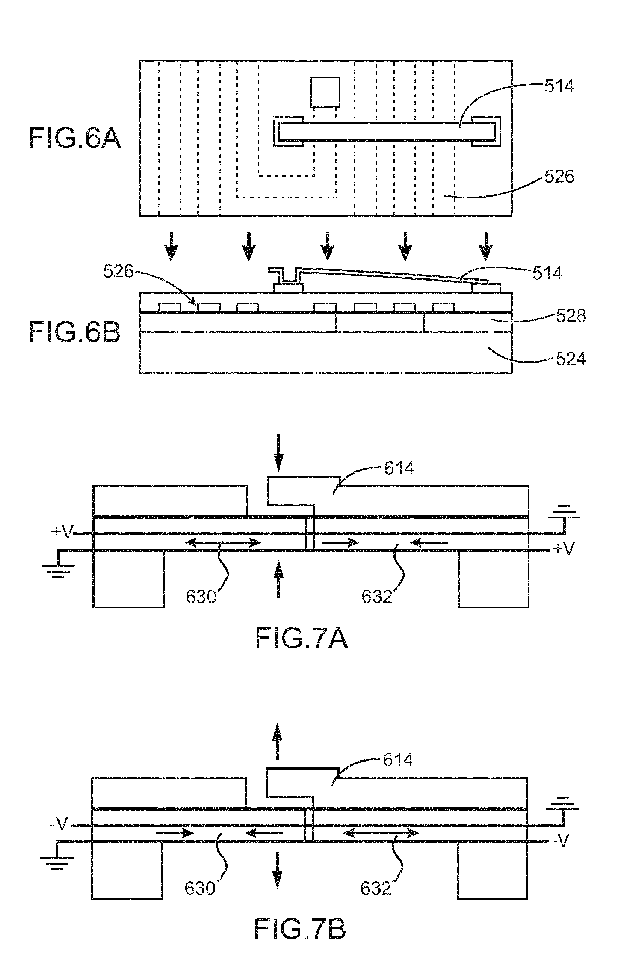

Un interrupteur à actuation magnétique est représenté sur les figures 6A et 6B, celui-comporte une partie mobile 514 de type cantilever et les moyens de commande sont formés par un aimant permanent 524 et une bobine 526 séparés par un substrat 528.

Sur les figures 7A et 7B, on peut voir un exemple de réalisation d'un interrupteur à commande piézoélectrique. La partie mobile 614 est également de type cantilever, celui-ci comporte deux portions 630, 632 de matériau piézoélectrique, par exemple du AIN, dont l'application d'une tension V positive provoque pour l'une une expansion 630 dans le plan et pour l'autre 632 une contraction, fermant l'interrupteur, et inversement l'application d'une tension V négative provoque pour l'une 630 une contraction et pour l'autre une expansion 632, ouvrant l'interrupteur.

Les structures d'interrupteur représentées sur les figures 6A à 7B sont des exemples de réalisation et ne sont en aucun cas limitatives.

Sur les figures 3A et 3B, on peut voir des exemples de réalisation de portes NON OU réalisées selon la présente invention. Sur la figure 3A, la porte comporte deux branches alimentées en parallèles par $V_{alim}$, l'une comportant deux interrupteurs en série 210, 212 et l'autre comportant deux interrupteurs en parallèles 220, 222. Chaque branche est chargée par sa propre capacité $C_L$. Une capacité $C_L$.est prévue entre les deux interrupteurs en série et les interrupteurs en parallèle. Sont représentées également les tensions V aux bornes de A et B.

Les interrupteurs peuvent être similaires à ceux représentés sur les figures 4, 5A et 5B.

Sur la figure 3B, la porte comporte deux interrupteurs 310, 312 en parallèle réalisant les commandes A et B, en série avec deux interrupteurs en parallèle 320, 322 réalisant les commandes et B complémentées. La source de tension est connectée aux interrupteurs 310, 312. Une capacité $C_L$.est prévu entre les deux interrupteurs en série et les interrupteurs en parallèle. Lorsque les interrupteurs 310 et 312 sont ouverts les interrupteurs 320 et 322 sont fermés. La commande A complémentée et la commande B complémentée peuvent être remplacées par les commandes A et B avec des interrupteurs différents, i.e. fermés sans application de tension de commande et ouverts par application d'une tension de commande.

Sur la figure 3C, on peut voir un exemple de porte NAN selon la présente invention mettant en oeuvre quatre interrupteurs mécaniques 410, 412, 420, 422. Sont représentées également les tensions V aux bornes de A et B.

De préférence tous les interrupteurs d'un même circuit logique sont similaires ou identiques afin de simplifier la réalisation et la commande du circuit.

Nous allons maintenant déterminer l'énergie dissipée pour un interrupteur mécanique à commande électrostatique et dans le cas d'un inverseur logique selon la présente invention.

L'inverseur selon la présente invention consomme de l'énergie uniquement lors des commutations, cette consommation est désignée consommation dynamique, sa consommation statique étant négligeable.

En effet, le contact mécanique étant établi par positionnement des entrées, l'interrupteur est conducteur quelle que soit la valeur de tension appliquée entre les deux pistes conductrices 10, 12 et une tension aussi faible soit-elle est transmise entre l'entrée et la sortie.

Le courant circulant entre les deux pistes est indépendant de la valeur de tension de commande, à l'inverse d'un interrupteur CMOS dans lequel le courant entre la source et le drain dépend de la valeur de la tension de seuil. La fermeture de l'interrupteur mécanique est effective à partir d'une certaine valeur de tension de commande, cependant celle-ci n'est pas comparable à la tension de seuil d'un transistor MOS car sa valeur n'intervient pas sur la valeur du courant qui traverse l'interrupteur et n'introduit donc pas de consommation dynamique non adiabatique. De plus l'électrode de commande étant électriquement isolée, il n'y a pas de consommation statique.

L'énergie dissipée peut alors s'écrire :

$$E_{meca} = \frac{R_{meca}C_L}{T} \cdot C_L \cdot V_{DD}{}^2 \qquad (I)$$

Avec $C_L$ la capacité des interconnexions,
$R_{meca}$ la résistance électrique des interconnexions et des contacts

A titre de comparaison, l'énergie de commutation d'un inverseur adiabatique à base de MOS est :

$$E_{MOS} = \frac{R_{mos}C_L}{T} \cdot C_L \cdot V_{DD}{}^2 + C_L \cdot V_T{}^2 \qquad (II)$$

En supposant que la période T est choisie de telle manière que le premier terme de l'expression (II) dans le cas d'un d'inverseur CMOS soit négligeable, on peut comparer :

$$E_{meca} = \frac{R_{meca}C_L}{T} \cdot C_L \cdot V_{DD}{}^2$$

et

$$E_{mos} = C_L \cdot V_T^2$$

Par exemple, $R_{meca}$ peut être aussi faible que 1000 Ohms pour une tension $V_{DD}$ de 1 V.

Le temps T de montée du signal de polarisation peut être choisi à 10 ns.

La capacité typique de la ligne de connexion est de 10 fF.

La tension de seuil d'une technologie CMOS avancée en faible consommation est de l'ordre de 300 mV.

Les deux énergies sont alors $C_L \cdot V_T^2$ pour la CMOS et $10^{-3} C_L \cdot V_{DD}^2$ pour la solution NEMS.

Comme cela a été expliqué précédemment, la tension de seuil de la technologie CMOS ne peut être réduite à cause de la consommation statique et comme il est possible d'envisager des tensions de quelques volts pour la tension d'alimentation $V_{DD}$, on constate que le circuit logique selon l'invention permet de réduire l'énergie dissipée d'un facteur de l'ordre de 100 par rapport à un circuit logique en technologique CMOS avancée.

Par exemple, en prenant des valeurs typiques de 300 mV pour la tension de seuil et de 1 V pour le tension d'alimentation du circuit logique selon l'invention, on obtient un facteur 100.

Ce facteur serait entre 100 et 1000 pour un temps T de 100 ns.

Par conséquent, grâce à l'invention on obtient un circuit logique à basse consommation.

En outre, grâce à la combinaison d'un fonctionnement en logique adiabatique et d'interrupteurs mécaniques selon l'invention, on peut réaliser des systèmes intégrés à basse consommation sans devoir utiliser des tensions d'alimentation basses. Pouvoir utiliser des tensions relativement hautes (de l'ordre du volt) est un grand avantage car les circuits fonctionnant à tension basse (100 mV ou moins) sont particulièrement sensibles aux perturbations électriques. Le fait d'avoir l'énergie de commutation quasi indépendante de la tension utilisée donne une grande souplesse à la conception des systèmes électroniques. De plus, la possibilité de faire varier la tension d'alimentation dans une vaste plage permet une optimisation plus facile des interrupteurs mécaniques par exemple en éliminant plus facilement les problèmes de collage ou les problèmes de claquage électrique.

Comme indiqué ci-dessus, une tension d'alimentation élevée permet en outre de résoudre le problème du collage des interrupteurs mécaniques.

Dans le cas de l'actuation électrostatique, la force F appliquée entre la partie mobile et l'électrode fixe lorsque le contact est établi, s'écrit :

$$F = \frac{\varepsilon_0 \cdot S \cdot V^2}{2(g - g_d)^2}$$

La résistance de contact se calcule classiquement par la formule de Sharvin :

$$R = 2\frac{4\rho\lambda}{3A}$$

- V la tension de commande des interrupteurs de l'inverseur,
- R la résistance du contact entre la partie mobile et les pistes,
- p la résistivité du métal utilisé dans la partie mobile,
- S la surface en regard de l'électrode fixe (notée 16 sur la figure 5A) et de l'électrode correspondante pour la partie mobile,
- $\lambda$ le libre parcours moyen des électrons dans le métal,
- A la surface de contact entre la partie mobile et les pistes,
- g est le jeu à l'état ouvert entre la partie mobile et l'électrode fixe (représenté sur la figure 5A),
- $g_d$ est le jeu, à l'état ouvert, entre la partie mobile et la base au niveau des zones destinées à entrer en contact (représenté sur la figure 5A).

Par ailleurs, la surface de contact A peut se calculer comme suit :

$$A = \frac{F}{H\xi}$$

- *H* étant la dureté du métal
- $\xi$ étant le coefficient d'élasticité de l'ordre de 0,3.

De manière préférentielle la tension de commande *V* est aussi la tension de sortie ou d'alimentation nominale, sa valeur est donc $V_{DD}$, ce qui permet de simplifier l'architecture de l'ensemble du circuit intégré, puisqu'une porte logique en commande une autre. Sinon la tension de sortie d'une porte logique serait transformée afin qu'elle forme une tension de commande d'une autre porte logique.

L'énergie de commutation en logique adiabatique pour une porte étage est alors, en supposant que les résistances de contact sont les contributions principales à la résistance totale ce qui est confirmé par la littérature :

$$E = \frac{32}{3}\frac{\rho\lambda H\xi}{\varepsilon_0 S}\left(g - g_d\right)^2 \frac{C_L{}^2}{T}$$

On constate donc de manière très surprenante que l'énergie dissipée est indépendante de la tension de commande et donc de la tension nominale d'alimentation, contrairement aux préjugés de l'homme du métier qui considère généralement qu'une basse consommation impose une tension d'alimentation faible.

La démonstration précédente s'applique dans le cas des interrupteurs à commande électrostatique. Pour les autres types de commande, il y a également un effet compensateur du même type. En effet, la résistance de contact dépend de l'actuation et donc de la tension de commande, mais pas nécessairement selon une loi inversement proportionnelle au carré de la tension comme dans l'interrupteur à commande électrostatique.

Le temps mis par la structure pour entrer en contact avec le substrat quand une tension est appliquée peut également se calculer en fonction de la tension appliquée et des caractéristiques de l'interrupteur. Ce temps devrait être inférieur au temps T choisi dans des architectures logiques classiques et donc devrait être de quelques nanosecondes si T est de 10 ns. La miniaturisation des interrupteurs mécaniques pourrait conduire à de telles valeurs. Dans tous les cas, des architectures logiques plus adaptées aux interrupteurs mécaniques permettent cependant de relâcher cette contrainte par exemple en réalisant des fonctions logiques plus complexes au niveau des portes élémentaires.

Il est alors possible de calculer le rapport entre l'énergie dissipée dans un circuit à base de transistors en logique adiabatique et celle dissipée dans un circuit selon l'invention, ce qui représente le facteur de mérite de l'invention par rapport aux circuits existants.

Ce facteur s'écrit :

$$\eta = \frac{3}{32}\frac{V_T{}^2 \varepsilon_0 S}{\rho\lambda H\xi\left(g - g_d\right)^2}\frac{T}{C_L}$$

On constate donc que la présente invention a d'autant plus d'intérêt quand T augmente et $C_L$ diminue.

T est avantageusement compris entre 1 et 100 ns.

Le facteur de mérite de l'invention peut s'écrire pour des valeurs typiques des constantes physiques mises en jeux :

$$\eta = 2\cdot 10^{-6}\frac{V_T{}^2}{C_L}TF$$

Le facteur de forme de l'interrupteur mécanique est défini par :

$$F = \frac{S}{(g - g_d)^2}$$

Cette relation donne le domaine d'applicabilité de l'invention. On cherche un facteur de mérite supérieur à 100 pour un facteur de forme donné, 1 000 par exemple.

Des valeurs typiques de 10 fF pour la capacité, de 10 ns pour T et de 200 mV pour la tension de seuil du circuit MOS conduisent à des valeurs de l'ordre de :

$$\eta = 8 \cdot 10^{-2} F$$

Pour obtenir un gain significatif de 80, le facteur de forme de 1000. Un interrupteur de gap 10 nm avec une surface de commande électrostatique de 300 nm $\times$ 300 nm serait compatible ce qui conduit à un encombrement raisonnable.

Reprenons la valeur théorique de l'énergie dissipée pour une actuation électrostatique.

$$E = \frac{32}{3} \frac{\rho \lambda H \xi}{\varepsilon_0 S} (g - g_d)^2 \frac{C_L^2}{T}$$

Pour une capacité d'interconnexion de 10, $10^{-15}$ F et pour une valeur de T égale à 10 ns, on obtient pour des dispositifs à couche métallique en exprimant l'énergie en kTa comme il est fréquent dans le domaine de la faible consommation.

$$E = 0{,}75 \cdot \frac{10^6}{F} kT_a$$

k étant la constante de Boltzmann.

Ta étant la température absolue en Kelvin Une valeur de 750 kTa est donc possible pour F égal à 1000 ce qui est exceptionnel comparé à la CMOS.

Cette valeur serait de 75 kTa pour une valeur de T de 100 ns.

Les exemples de portes logiques représentés sur les figures 2 et 3 ne sont en aucun cas limitatifs et s'appliquent à tout type d'architecture de porte logique. La porte NOR a été donnée comme exemple mais les portes classiques NAND, ET et OU sont également réalisables selon ce principe. Il en est de même pour les fonctions obtenues par combinaison de portes élémentaires (additionneurs, registres, cellule mémoire SRAM Ou DRAM). Il est à noter également que les portes utilisées dans le calcul réversible (portes de Fredkin, de Toffoli et de Feynman) sont également réalisables selon ce principe.

Les circuits logiques ainsi réalisés sont particulièrement adaptés à des applications requérant une consommation très faible, par, exemple les systèmes autonomes portables.

La présente invention est également particulièrement adaptée à des systèmes à haut degré de " parallélisation ", i.e. des systèmes comportant un grand nombre de circuits fonctionnant à des fréquences relativement lentes, donc demandant des fréquences de fonctionnement par bloc assez faibles.

Les circuits selon la présente invention peuvent être réalisés par les technologies classiques de la microélectronique utilisées pour réaliser les systèmes MEMS OU NEMS, par exemple par une technologie silicium, par dépôt et gravure de couche mais toute autre technologie permettant de réaliser des interrupteurs mécaniques miniaturisés est applicable.

**Revendications**

1. Circuit logique pour circuit intégré comportant :

   - une source de tension d'alimentation apte à charger et à décharger à courant quasi constant une ligne d'interconnexion à travers des interrupteurs mécaniques,
   - une ligne d'interconnexion,
   - des interrupteurs mécaniques, lesdits interrupteurs étant des interrupteurs microélectromécaniques ou des interrupteurs nanoélectromécaniques,
   - des moyens de commutation desdits interrupteurs.

2. Circuit logique selon la revendication 1, dans lequel la source de tension d'alimentation est variable selon au moins trois phases successives, une première phase d'augmentation de la tension d'une valeur nulle à une tension nominale ($V_{DD}$), une deuxième phase de maintien de la tension d'alimentation à la tension nominale ($V_{DD}$) et une troisième phase de diminution de la tension d'alimentation de la tension nominale ($V_{DD}$) à une valeur nulle, et au moins deux interrupteurs mécaniques (2, 4, 210, 212, 222), lesdits interrupteurs (2, 4" 210, 212, 222) étant des interrupteurs microélectromécaniques ou des interrupteurs nanoélectromécaniques

3. Circuit logique selon la revendication 2, dans lequel la durée de la première phase est comprise entre 1 et 100 ns.

4. Circuit logique selon la revendication 2 ou 3, dans lequel la tension d'alimentation nominale ($V_{DD}$) est comprise entre 100 mV et 10 V.

5. Circuit logique selon l'une des revendications 1 à 4, dans lequel chaque interrupteur (2, 4, 210, 212, 222) comporte deux pistes conductrices électriques (10, 12), l'une des pistes conductrices étant connectée à la source de tension d'alimentation et une partie mobile (14) destinée à venir en contact avec les deux pistes dans un état de fermeture de l'interrupteur, et dans lequel les moyens de commutation mettent en oeuvre une tension de commande pour déplacer la partie mobile.

6. Circuit logique selon la revendication 5, dans lequel la tension d'alimentation est égale à la tension de commande.

7. Circuit logique selon la revendication 5 ou 6, dans lequel les moyens de commutation sont de type électrostatique et comportent une électrode fixe (16) en regard d'une partie au moins de la partie mobile (14) et des moyens d'application de la tension de commande positive pour attirer la partie mobile (14) vers l'électrode fixe (16) et mettre en contact la partie mobile (14) avec les pistes conductrices (10, 12).

8. Circuit logique selon la revendication 5 ou 6, dans lequel les moyens de commutation sont de type magnétique ou de type piézoélectrique.

9. Circuit logique selon l'une des revendications 1 à 8, dans lequel le circuit logique est t un inverseur logique.

10. Circuit logique selon l'une des revendications 1 à 8, dans lequel le circuit logique est un circuit NON OU ou NON ET ou ET ou OU ou une porte de Toffoli ou une porte de Fredkin ou une porte de Feynman.

11. Circuit intégré comportant au moins un premier et un deuxième circuit logique selon l'une des revendications 1 à 10.

12. Circuit intégré selon la revendication 11 en combinaison avec la revendication 6, la tension de sortie de la première porte commandant la deuxième porte.

FIG.1A

FIG.1B

FIG.1C

FIG.1D

FIG.2

FIG.3A

FIG.3B

FIG.3C

FIG.4

FIG.5A

FIG.5B

FIG.6A

514

526

FIG.6B

526

514

528

524

614

+V

+V

630

632

FIG.7A

614

-V

-V

630

632

FIG.7B

Europäisches
Patentamt

European
Patent Office

Office européen
des brevets

**RAPPORT DE RECHERCHE EUROPEENNE**

Numéro de la demande

EP 12 17 7104

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2005/253571 A1 (FRANK MICHAEL P [US] ET AL) 17 novembre 2005 (2005-11-17) <br> * le document en entier * <br> * figures 1,7,8 * | 1-12 | INV. <br> H03K19/00 <br> H03K19/02 |
| Y | US 2002/153583 A1 (FRAZIER GARY A [US] ET AL) 24 octobre 2002 (2002-10-24) <br> * le document en entier * <br> * alinéa [0047] - alinéa [0058]; figure 9 * | 1-12 | |
| A | US 5 638 946 A (ZAVRACKY PAUL M [US]) 17 juin 1997 (1997-06-17) <br> * colonne 5, ligne 39 - colonne 13, ligne 38; figures 2,9-11 * | 1-12 | |
| A | US 6 153 839 A (ZAVRACKY PAUL M [US] ET AL) 28 novembre 2000 (2000-11-28) <br> * colonne 4, ligne 1 - ligne 50; figures 3,4,12-14 * <br> * colonne 10, ligne 13 - ligne 51 * | 1-12 | DOMAINES TECHNIQUES RECHERCHES (IPC) |
| A | BERGSTROM P ET AL: "Micromechanical logic", 19891203; 19891203 - 19891206, 3 décembre 1989 (1989-12-03), pages 878-879, XP010079779, <br> * le document en entier * | 1-12 | H03K |

-/--

Le présent rapport a été établi pour toutes les revendications

| Lieu de la recherche | Date d'achèvement de la recherche | Examinateur |
|---|---|---|
| La Haye | 23 août 2012 | Jepsen, John |

Europäisches
Patentamt

European
Patent Office

Office européen
des brevets

**RAPPORT DE RECHERCHE EUROPEENNE**

Numéro de la demande

EP 12 17 7104

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | MICHAEL P FRANK ED - ANONYMOUS: "Reversible Computing and Truly Adiabatic Circuits: Truly Adiabatic Circuits: The Next Great Challenge for Digital Engineering", DESIGN, APPLICATIONS, INTEGRATION AND SOFTWARE, 2006 IEEE DALLAS/CAS W ORKSHOP ON, IEEE, PI, 1 octobre 2006 (2006-10-01), pages 31-38, XP031052615, ISBN: 978-1-4244-0669-2 * le document en entier * ----- | 1-12 | |
| A,D | ATHAS W C ET AL: "LOW-POWER DIGITAL SYSTEMS BASED ON ADIABATIC-SWITCHING PRINCIPLES", IEEE TRANSACTIONS ON VERY LARGE SCALE INTEGRATION (VLSI) SYSTEMS, IEEE SERVICE CENTER, PISCATAWAY, NJ, USA, vol. 2, no. 4, 1 décembre 1994 (1994-12-01), pages 398-407, XP000483628, ISSN: 1063-8210, DOI: 10.1109/92.335009 * le document en entier * ----- | 1-12 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 23 août 2012 | Jepsen, John |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...........................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 17 7104

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-08-2012

| Document brevet cité au rapport de recherche | | Date de publication | Membre(s) de la famille de brevet(s) | | Date de publication |
|---|---|---|---|---|---|
| US 2005253571 | A1 | 17-11-2005 | US 2005253571 A1 | | 17-11-2005 |
| | | | WO 2005114840 A2 | | 01-12-2005 |
| US 2002153583 | A1 | 24-10-2002 | US 2002153583 A1 | | 24-10-2002 |
| | | | US 2002153584 A1 | | 24-10-2002 |
| US 5638946 | A | 17-06-1997 | AUCUN | | |
| US 6153839 | A | 28-11-2000 | US 6153839 A | | 28-11-2000 |
| | | | WO 0024021 A1 | | 27-04-2000 |

Pour tout renseignement concernant cette annexe : voir Journal Officiel de l'Office européen des brevets, No.12/82

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **W C ATHAS.** Low power Digital systems based on adiabatic switching principles. *IEEE transactions on VLSI systems,* Décembre 1994, vol. 2 (04